(19) Europäisches Patentamt
European Patent Office
Office européen des brevets

(11) EP 2 893 555 B1

(12) FASCICULE DE BREVET EUROPEEN

(45) Date de publication et mention
de la délivrance du brevet:
**31.03.2021 Bulletin 2021/13**

(21) Numéro de dépôt: **13783089.9**

(22) Date de dépôt: **03.09.2013**

(51) Int Cl.:
**H01L 21/67** *(2006.01)*     **B26D 3/28** *(2006.01)*
**B26D 7/00** *(2006.01)*     **B26D 7/08** *(2006.01)*

(86) Numéro de dépôt international:
**PCT/IB2013/001921**

(87) Numéro de publication internationale:
**WO 2014/037791 (13.03.2014 Gazette 2014/11)**

(54) **DISPOSITIF DE SÉPARATION DE DEUX SUBSTRATS**

VORRICHTUNG ZUM TRENNEN ZWEIER SUBSTRATE

DEVICE FOR SEPARATING TWO SUBSTRATES

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **07.09.2012 FR 1258370**

(43) Date de publication de la demande:
**15.07.2015 Bulletin 2015/29**

(73) Titulaire: **Soitec
38190 Bernin (FR)**

(72) Inventeur: **LANDRU, Didier
F-38190 Le Champs-Prés-Froges (FR)**

(74) Mandataire: **Grünecker Patent- und
Rechtsanwälte
PartG mbB
Leopoldstraße 4
80802 München (DE)**

(56) Documents cités:
EP-A1- 0 824 267     EP-A2- 1 107 295
EP-A2- 1 197 987     WO-A1-2008/040782
FR-A1- 2 823 372     FR-A1- 2 828 428

**Description**

DOMAINE DE L'INVENTION

L'invention concerne un dispositif de séparation de deux substrats, au niveau d'une interface dite "de séparation", au moins l'un de ces deux substrats étant destiné à être utilisé dans l'électronique, l'optique, l'optoélectronique et/ou le photovoltaïque, ces deux substrats formant ensemble une structure.

ARRIERE-PLAN DE L'INVENTION

Cette séparation mécanique peut être effectuée le long de différents types d'interfaces de séparation.

Un premier type d'interface de séparation est une interface de collage, par exemple une interface de collage par adhésion moléculaire, tel que dans EP 0824267 A1.

Par "collage par adhésion moléculaire", on désigne un collage par contact intime entre deux surfaces mettant en œuvre des forces d'adhésion, principalement les forces de Van der Walls, et n'utilisant pas de couche adhésive.

Une structure apte à être séparée le long d'une interface de collage, par exemple par adhésion moléculaire, est connue de. L'homme du métier sous l'appellation de structure "décollable" ou structure à interface de collage réversible (en anglais *"debondable structure"*).

Sans vouloir être limitatif, on peut toutefois considérer que ce type de structure décollable peut être utilisé principalement dans quatre applications différentes :

a) collage d'un raidisseur mécanique : il peut être souhaitable de coller un raidisseur mécanique sur un substrat ou une couche mince fragile pour éviter son endommagement ou sa rupture durant certaines étapes de fabrication, puis de pouvoir retirer ce raidisseur mécanique lorsque sa présence n'est plus nécessaire ;
b) rectification d'un mauvais collage : le décollement permet de décoller deux substrats qui n'auraient pas été collés correctement une première fois, puis de les recoller après nettoyage, afin d'améliorer la rentabilité d'un procédé de fabrication et d'éviter par exemple la mise au rebut de substrats mal collés ;
c) protection temporaire : lors de certaines étapes de stockage ou de transport de substrats, notamment dans des boites en matière plastique, il peut être utile de protéger temporairement leurs surfaces, notamment celles destinées à être utilisées ultérieurement pour la fabrication de composants électroniques, afin d'éviter tout risque de contamination. Une solution simple consiste à coller deux substrats de façon que leurs faces à protéger soient collées respectivement l'une avec l'autre, puis à décoller ces deux substrats lors de leur utilisation finale ;
d) double transfert d'une couche : il consiste à réaliser une interface de collage réversible entre une couche active et un premier substrat support (éventuellement réalisé en un matériau coûteux), puis à transférer cette couche active sur un second substrat définitif, par décollement de ladite interface de collage réversible.

Un deuxième type d'interface de séparation est une interface dite "de fragilisation", qui désigne par exemple une zone obtenue par implantation d'espèces atomiques. Une séparation selon une telle interface est utilisée dans un procédé de transfert d'une couche d'un premier substrat vers un second, tel que celui connu par exemple sous la dénomination commerciale "Smart Cut®".

Une interface de fragilisation peut également être une zone poreuse.

Un troisième type d'interface de séparation est une interface entre un premier et un second matériau, qui peuvent avoir été joints l'un à l'autre par un apport du second sur le premier, par une technique de dépôt, par exemple dépôt CVD ou une épitaxie.

Quelles que soient les applications envisagées, il est nécessaire d'effectuer cette séparation, sans endommager, rayer, ou contaminer la surface des deux substrats situés de part et d'autre de l'interface séparation et sans casser ces deux substrats. En fonction des différentes applications, ces deux "substrats à séparer" peuvent être deux couches d'un même substrat ou deux substrats distincts.

En outre, plus les dimensions des deux substrats de la structure à séparer sont importantes ou plus leur énergie de séparation (c'est-à-dire l'énergie à apporter pour les séparer) est forte et plus la séparation est difficile à réaliser, notamment sans dommages.

On sait par ailleurs d'après les travaux de recherche de Maszara au sujet de l'énergie de séparation de deux substrats, qu'il est possible de mesurer l'énergie de collage entre ces deux substrats, en introduisant une lame mince entre les deux, au niveau de leur interface de collage (voir l'article de W.P Maszara, G. Goetz, A. Caviglia et J. B. McKitterick : J. Appl Phys. 64 (1988) 4943).

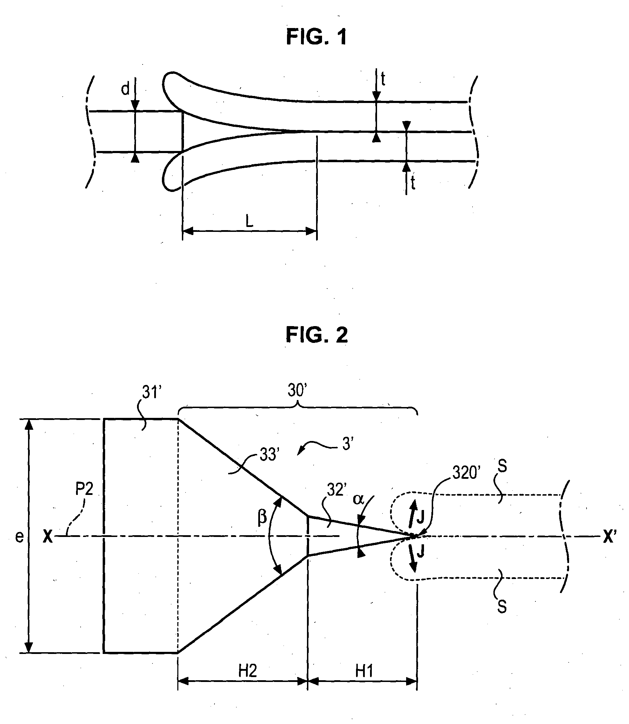

On pourra se reporter à ce sujet à la figure 1 jointe, qui est un schéma représentant l'insertion d'une lame mince d'épaisseur d entre deux substrats, avec pour effet de produire une ouverture des deux substrats sur une longueur L.

Maszara a établi la relation suivante :

$$L = \sqrt[4]{\frac{3Et^3d^2}{32\gamma}}$$

dans laquelle d représente l'épaisseur de la lame insérée entre les deux substrats collés, t représente l'épaisseur de chacun des deux substrats collés E représente le module de Young selon l'axe du décollement, γ représente l'énergie de collage et L représente la longueur de la fissure entre les deux substrat à l'équilibre.

Dans la formule ci-dessus, on part de l'hypothèse que les deux substrats sont de dimensions identiques.

Grâce à la relation précitée, il est possible en mesurant L, de déterminer l'énergie de collage γ.

On notera toutefois, que dans cet article, le décollement à l'aide d'une lame n'est pas utilisé comme une fin en soi, mais simplement pour mesurer l'énergie de collage. De ce fait, la lame utilisée est mince (entre 0,05 mm et 0,5 mm d'épaisseur) et risque de provoquer des rayures sur les faces collées des deux substrats. Dans les essais de Maszara, ceci n'a pas d'importance puisque le but est de mesurer une énergie de collage. Toutefois, lorsque l'on souhaite réutiliser les substrats, une telle technique n'est pas envisageable.

Dans la mesure où les substrats ou couches à séparer présentent des rigidités suffisantes pour être séparés avec une lame, il est possible de les séparer en les écartant suffisamment l'un de l'autre, au niveau de leur bord chanfreiné, ce qui a pour effet de créer une onde de séparation. Celle-ci se propage depuis le point du bord des substrats où elle est initiée, vers toute la surface de ces substrats.

On notera toutefois que bien que la lame soit insérée entre les chanfreins des deux substrats, la séparation proprement dite s'effectue en fait au niveau de l'interface de séparation où l'énergie de liaison est la plus faible, c'est-à-dire où la quantité d'énergie à apporter pour provoquer la séparation est la plus faible.

On connaît déjà, d'après le document US 7 406 994, un dispositif de coupe d'une structure comprenant deux plaquettes, collées l'une contre l'autre via une interface de collage, et dont l'une présente une zone de fragilisation.

Ce dispositif de coupe comprend un châssis comportant deux parties fixes et une partie centrale mobile, une lame de coupe mobile en translation dans le plan de l'interface de collage et un élément de positionnement fixe, disposé sur le châssis à l'opposé de la lame. La structure à découper est disposée horizontalement sur le châssis et maintenue sur une portion de son bord par ledit élément de positionnement.

Dès que la lame a avancé suffisamment pour être insérée dans la gorge existant entre les deux plaquettes au niveau de l'interface de collage, la partie centrale mobile du châssis est écartée, de sorte que les deux plaquettes peuvent s'écarter l'une de l'autre. La séparation s'effectue le long de la zone de fragilisation.

Ce dispositif présente l'inconvénient que, une fois la séparation des deux plaquettes effectuée, celles-ci ne sont pas maintenues et risquent de s'endommager ou de se coller l'une à l'autre de nouveau.

La lame de coupe utilisée présente une forme en arc de cercle, concave dont le bord d'attaque présente une section transversale triangulaire d'angle constant (c'est à dire une arête et deux faces en biseau).

En outre, comme précisé en colonne 7, lignes 22 et 23, et en colonne 6, lignes 23 et 24 de ce document, l'épaisseur de la lame est de quelques millimètres et de préférence de l'ordre de 5 mm.

Ce document ne donne toutefois aucun enseignement sur la possibilité de séparer de séparer des substrats de grand diamètre ou présentant une énergie de collage importante, par exemple d'au moins 1 J/m$^2$, voire 1,5 J/m$^2$. Une telle lame mince ne permet pas de le faire car elle ne permet pas de les écarter suffisamment.

En outre, le risque de rayer les surfaces avec une telle lame n'est pas négligeable.

De plus, l'angle du bord d'attaque de la lame est important, (indiqué comme étant de l'ordre de 60°). De ce fait, lors de l'introduction de cette lame au niveau des chanfreins respectifs des deux substrats à détacher, la résultante des forces exercées sur les deux substrats est dirigée principalement dans une direction parallèle à l'interface de collage et non perpendiculaire à celle-ci. Il est donc difficile d'écarter les deux substrats l'un de l'autre.

L'invention a pour objectif de résoudre les inconvénients précités de l'état de la technique et notamment de fournir un dispositif qui permette de détacher deux substrats (ou deux couches), reliés entre eux par une interface de de séparation, y compris des substrats de dimensions importantes pouvant atteindre 300 mm de diamètre, ou dont l'énergie de collage à l'interface est élevée, par exemple d'au moins 1 J/m$^2$, et ce, sans les rayer, les contaminer, les casser ou les recoller par inadvertance.

A cet effet, l'invention est définie par la revendication 1.

Dans la suite de la description et des revendications, le terme "substrat" couvre un substrat mono ou multicouches.

Les revendications 2-11 présentent d'autres caractéristiques avantageuses de l'invention.

## BREVE DESCRIPTION DES DESSINS

D'autres caractéristiques et avantages de l'invention apparaîtront de la description qui va maintenant en être faite, en référence aux dessins annexés, qui en représentent, à titre indicatif mais non limitatif, un mode de réalisation possible.

Sur ces dessins :

- la figure 1 est un schéma représentant la méthode utilisée par Maszara pour déterminer l'énergie de collage entre deux substrats;
- les figures 2 et 4 sont des vues schématiques en coupe transversale d'un mode de réalisation de l'outil de séparation du dispositif conforme à l'invention et d'un exemple de réalisation de l'outil de séparation non conforme à l'invention respectivement, deux substrats ayant en outre été représentés de façon schématique sur la figure 2 ;

- les figures 3 et 5 sont des vues en perspective d'un autre mode de réalisation de l'outil de séparation et d'un autre exemple de réalisation de l'outil de séparation non conforme à l'invention respectivement;

- les figures 6 et 7 sont des schémas représentant, en section transversale verticale, deux variantes de réalisation de l'organe de retenue du dispositif de séparation conforme à l'invention ; et

- les figures 8 et 9 sont des vues respectivement de face et de côté d'un mode de réalisation du dispositif de séparation conforme à l'invention.

## DESCRIPTION DETAILLEE D'UN MODE DE REALISATION

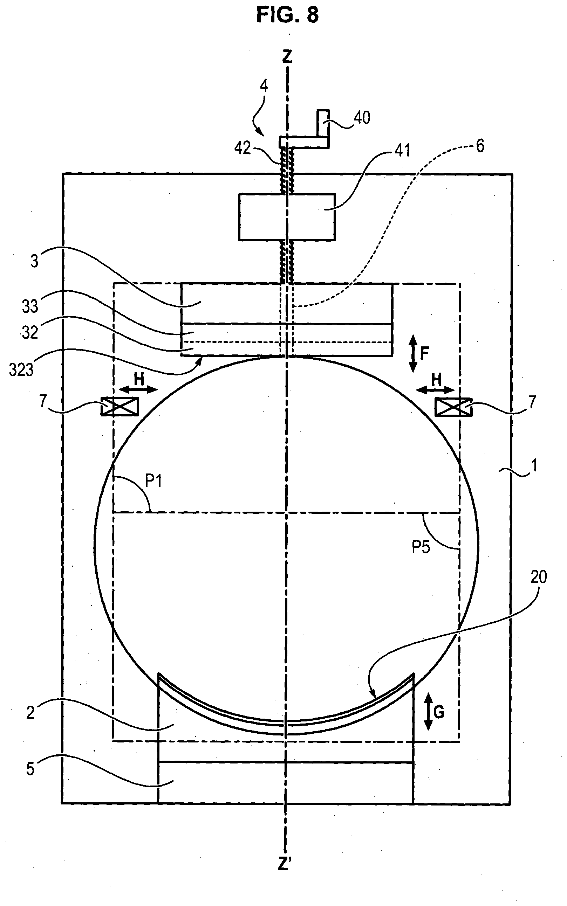

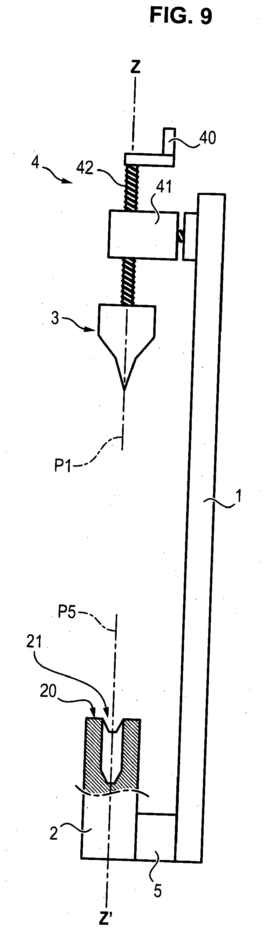

Un mode de réalisation possible du dispositif de séparation de deux substrats conforme à l'invention va maintenant être décrit en faisant référence aux figures 8 et 9.

D'une manière générale, ce dispositif comprend un support 1, un organe de retenue 2 de la structure à séparer, un outil de séparation 3, des moyens 4 et 5 de déplacement respectivement de l'outil de séparation 3 et de l'organe de retenue 2, par rapport au dit support 1.

On notera toutefois que le dispositif pourrait ne comprendre que l'un des deux moyens de déplacement 4 ou 5.

Le support 1 est une plaque plane rectangulaire. Il pourrait présenter une autre forme dès lors qu'il permet le montage et le fonctionnement de l'organe 2 et de l'outil 3, comme décrit ultérieurement.

Le dispositif de séparation, représenté sur les figures 8 et 9, est destiné à recevoir une structure à séparer qui est disposée verticalement et il permet d'opérer la séparation dans un plan vertical. En conséquence, la plaque du support 1 est érigée verticalement et dans la suite de la description et des revendications, les termes "vertical", "horizontal", "supérieur", "inférieur", "haut", "bas" sont à prendre en considération par rapport à la position du dispositif de séparation représentée sur les figures 8 et 9.

Toutefois, ce dispositif de séparation pourrait être utilisé horizontalement.

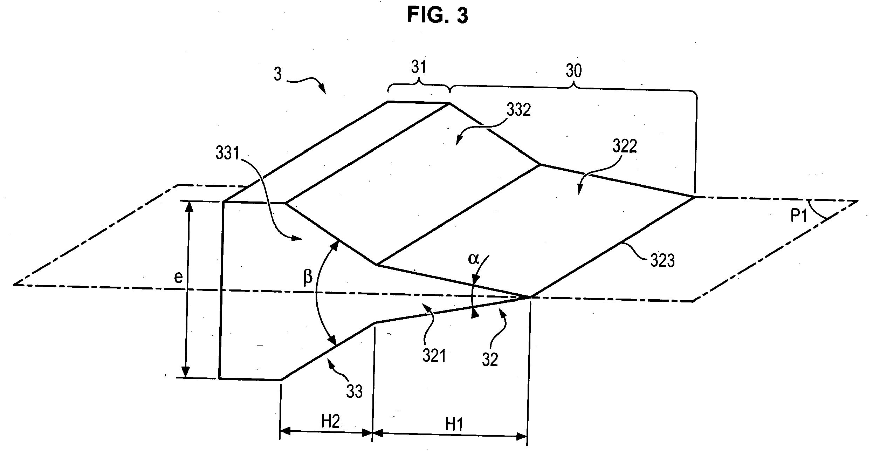

Un premier mode de réalisation de l'outil de séparation 3 va maintenant être décrit en faisant référence à la figure 3.

L'outil de séparation 3 comprend une partie avant 30 ou "bord d'attaque", qui se prolonge par une partie arrière 31.

La partie arrière 31 a de préférence la forme d'un parallélépipède rectangle et sert à la fixation sur le support 1.

Le bord d'attaque 30 comprend lui-même successivement de l'avant vers l'arrière (c'est-à-dire de la droite vers la gauche de la figure 3), une partie effilée 32 et une partie évasée 33.

La partie effilée 32 a la forme d'un prisme triangulaire dont la base est un triangle isocèle. Les deux faces d'extrémité en forme de triangle isocèle sont référencées 321, tandis que les deux faces rectangulaires longitudinales situées dans le prolongement des côtés de même longueur des deux triangles isocèles 321 sont référencées 322. L'arête libre ou arête avant du prisme, située à la jonction des deux faces 322 porte la référence 323.

L'angle a entre les deux faces latérales 322, dénommé ci-après "angle au sommet" est inférieur à 30°, de préférence égal à 10°.

La hauteur H1 de la face d'extrémité 321 est avantageusement comprise entre 2 mm et 20 mm, de préférence égale à 10 mm.

La partie évasée 33 a la forme d'un polyèdre à six faces dont les deux faces d'extrémité 331 ont la forme d'un trapèze isocèle. Les deux faces rectangulaires longitudinales situées dans le prolongement des côtés de même longueur des deux trapèzes isocèles 331 sont référencés 332.

L'angle $\beta$ entre les deux faces longitudinales 332 est supérieur à 30°, de préférence égal à 60°.

La hauteur H2 de la face d'extrémité 331 est avantageusement comprise entre 10 mm et 100 mm, de préférence égale à 50 mm.

Enfin, l'épaisseur e de l'outil de séparation 3, prise au niveau de labase de la face trapézoïdale 331 est avantageusement supérieure à deux fois le produit de la tangente de la moitié de l'angle au sommet $\alpha$ de la partie effilée 32 par la hauteur H1 de cette même partie, et de préférence est égale à 50 mm.

Par ailleurs, on notera que le bord d'attaque 30 présente un plan de symétrie longitudinal P1, qui inclut l'arête avant 323.

Le bord d'attaque 30 a la forme générale d'un élément rectiligne allongé.

Une variante de realisation de l'outil de séparation (référence 3') va maintenant être décrite en faisant référence à la figure 2.

L'outil de séparation 3' diffère de l'outil 3 précédemment décrit en ce que la partie effilée 32' de son bord d'attaque 30' a la forme d'un cône, d'angle au sommet $\alpha$ (sommet référencé 320') et que la partie évasée 33' a la forme d'un tronc de cône d'angle $\beta$. La partie arrière 31' a de préférence une forme cylindrique.

Les autres dimensions restent identiques.

L'outil de séparation 3' présente une multitude de plans de symétrie passant par son axe de révolution X-X'. Un seul référencé P2 a été schématisé sur la figure 2.

La paroi extérieure du bord d'attaque des outils 3 et 3' présente donc une rupture de pente.

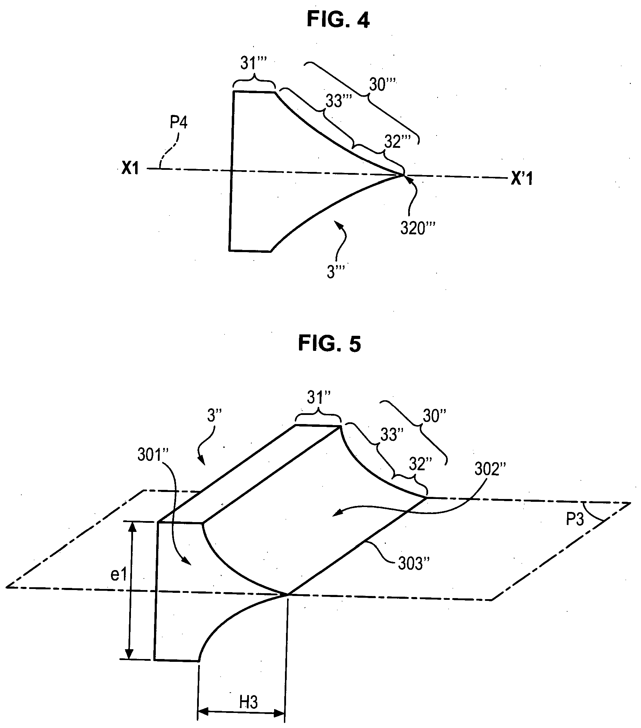

Un exemple de réalisation de l'outil de séparation non conforme à l'invention mais utile à sa compréhension (référencé 3") va maintenant être décrit en liaison avec la figure 5.

Il diffère de l'outil 3 en ce que son bord d'attaque 30" présente la forme générale d'un prisme dont la base a la forme d'un triangle isocèle mais dont les deux côtés égaux sont concaves. La partie arrière 31" a de préférence la forme d'un parallélépipède rectangle.

Les deux faces d'extrémité sont référencées 301", les deux faces concaves 302" et l'arête qui les joint 303".

De préférence encore, chaque face 302" présente le profil d'une demi-parabole, le sommet de la parabole étant situé au niveau de l'intersection avec la partie arrière 31".

Le bord d'attaque 30" présente donc toujours une partie effilée 32" et une partie évasée 33", mais sans rupture de pente. En outre, il a la forme générale d'un élément rectiligne allongé.

La hauteur H3 de la face 30" est de préférence comprise entre 10 mm et 120 mm, de preference encore égale à 60 mm. Son épaisseur e1 est de préférence supérieure à 1 mm, de préférence encore comprise entre 1 mm et 65 mm ou mieux encore égale à 50 mm.

Enfin, le bord d'attaque 30" présente un plan de symétrie longitudinal P3 qui inclut l'arête avant 303".

La forme concave des faces 302" (et à plus forte raison la forme semi-parabolique de celles-ci) est particulièrement avantageuse, car elle permet de rendre l'avancement de l'outil de séparation proportionnel à l'avancement de l'onde de séparation des deux substrats de la structure à séparer.

On sait en effet que la longueur L de l'onde de séparation entre les deux substrats est proportionnelle à la racine carrée de la distance d'écartement entre les deux substrats.

Une variante de l'exemple de réalisation de l'outil de séparation non conforme à l'invention référencée 3''' est décrite ci-après avec la figure 4.

L'outil 3''' diffère de l'outil 3" en ce que son bord d'attaque 30''', qui se décompose en une partie effilée 32''' et une partie évasée 33''', a la forme d'un cône dont la paroi périphérique est concave, de préférence parabolique. La partie arrière 31''' est de préférence cylindrique. Le sommet du cône est référencé 320'''.

L'un de ses plans de symétrie P4 passant par son axe de révolution X1 - X'l a été représenté sur la figure 4.

L'outil de séparation 3, 3', 3", 3''' ou à tout le moins son bord d'attaque 30, 30', 30", 30''' est réalisé de préférence dans un matériau à faible coefficient de friction, tel que du polytétrafluoroéthylène (PTFE), ou dans un matériau recouvert d'un lubrifiant.

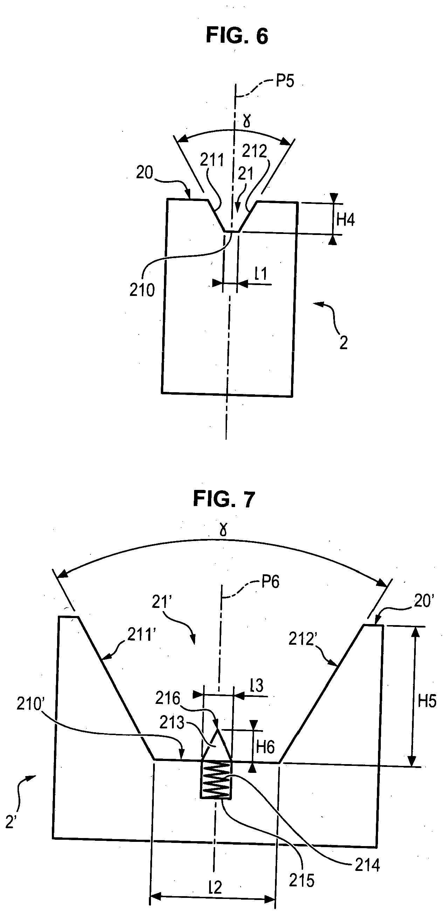

Un premier mode de réalisation de l'organe de retenue 2 va maintenant être décrit en liaison avec les figures 6, 8 et 9.

L'organe de retenue 2 de la structure à séparer présente la forme générale d'un parallélépipède rectangle dont la face longitudinale supérieure 20 est incurvée en forme d'arc-de-cercle, de préférence d'environ 70°. Vu de face, cet organe de retenue présente donc une forme concave dont la concavité est orientée vers le haut.

La face supérieure 20 présente sur toute sa longueur une gorge longitudinale 21, débouchant vers le haut.

Comme cela apparaît mieux sur la vue de détail de la figure 6, cette gorge 21 présente un fond 210, bordé par deux parois inclinée 211 et 212.

Ces parois latérales inclinées 211 et 212 forment entre elles un angle y, de préférence supérieur ou égal à 8°.

La largeur l1 du fond 210 est de préférence comprise entre 1,5 mm et 4 mm. En dessous de 1,5 mm, il serait difficile d'y insérer une structure composée de deux substrats, tels que ceux que l'on trouve couramment sur le marché.

Par ailleurs, la hauteur H4 de la gorge 21 est de préférence d'au moins 10 mm, afin de retenir correctement le bord de la structure dont le diamètre peut atteindre 300 mm.

La gorge 21 présente en outre un plan de symétrie longitudinal vertical P5 qui suit le fond 210.

Une variante de réalisation de l'organe de retenue va maintenant être décrite en liaison avec la figure 7.

Cet organe de retenue est référencé 2'. Il diffère de l'organe de retenue 2 uniquement par la forme de sa gorge 21'.

Celle-ci présente un fond 210', bordé par deux parois latérales longitudinales 211', 212', inclinées vers le haut et l'extérieur, et qui forment entre elles un angle $\gamma$ de préférence supérieur ou égal à 8°. Le fond 210' suit le contour en arc de cercle de la face supérieure 20'.

De préférence, la largeur l2 du fond 210' est comprise entre 1,5 mm et 4 mm et sa hauteur H5 est d'au moins 10 mm.

En outre, et contrairement au précédent mode de réalisation, le fond 210' est muni d'un ergot central 213 présentant avantageusement, en section transversale verticale, la forme d'un triangle isocèle dont la pointe 216 est dirigée vers le haut. De préférence, la hauteur H6 de l'ergot est comprise entre 50 $\mu$m et 600 $\mu$m et sa largeur l3 est comprise entre 50 $\mu$m à 300 $\mu$m. On notera à cet effet que l'ergot 213 a été représenté à une échelle supérieure à celle du reste de la gorge 21'.

Cet ergot présente en section verticale longitudinale, une forme en portion d'arc-de-cercle qui suit le contour de la face supérieure 20' de l'organe de retenue 2'.

De façon avantageuse, l'ergot 213 est monté sur un ressort 214 logé dans un évidement 215, ménagé dans le fond 210'.

Le ressort 214 tend en permanence à repousser l'ergot 213 vers le haut.

Enfin, la gorge 21' présente un plan de symétrie vertical longitudinal référencé P6.

Comme on peut le voir sur les figures 8 et 9, l'outil de séparation 3 et l'organe de retenue 2 sont montés sur le support 1, de façon que l'outil 3 soit au-dessus de l'organe 2 et que leurs plans de symétrie respectifs P1 et P5 soient confondus et orientés verticalement. Il en est de même si l'organe de retenue 2 est remplacé par l'organe de retenue 2' de plan de symétrie P6 et/ou si l'outil de séparation 3 est remplacé par l'outil de séparation 3', 3" ou 3''' de plans de symétrie respectifs P2, P3, P4.

De façon avantageuse, l'outil de séparation 3, 3', 3", 3''' est muni de moyens de déplacement 4 qui permettent de le déplacer verticalement par rapport au support 1, afin de le rapprocher ou au contraire de l'écarter, de préférence sur une course limitée; de l'organe de retenue 2, 2'.

Dans le mode de réalisation représenté sur les figures 8 et 9, ces moyens 4 sont des moyens manuels, constitués d'une manivelle 40 dont la tige filetée 42 se déplace à l'intérieur d'un orifice longitudinal taraudé ménagé verticalement dans une pièce 41 solidaire du support 1. La rotation de la manivelle 40 entraîne le déplacement de l'outil de séparation 3, 3', 3" ou 3''' dans le plan de symétrie vertical P1, P2, P3 ou P4 selon une direction matérialisée par l'axe Z-Z' et la flèche F (voir figure 8).

Dans une version industrielle du dispositif, ces moyens 4 pourraient être constitués d'un vérin, par exemple.

L'organe de retenue 2, 2' peut également être muni de moyens de déplacement 5, qui permettent de le déplacer verticalement par rapport au support 1, afin de le rapprocher ou au contraire de l'écarter, de préférence sur une course limitée, de l'outil de séparation 3, 3', 3", 3'''. Ce déplacement s'effectue dans le plan de symétrie vertical P5 ou P6, selon une direction matérialisée par l'axe Z-Z' et la flèche G (voir figure 8). Cette course limitée est de l'ordre de plusieurs centimètres.

Ces moyens 5 sont simplement schématisés sur les figures 8 et 9. Ils peuvent être identiques aux moyens de déplacement 4.

Enfin, de façon avantageuse, le dispositif comprend également une buse de pulvérisation 6 d'axe Z-Z', disposée au sein de l'outil de séparation 3, 3', 3" ou 3''' de façon à déboucher au niveau de l'arête avant 323, 303" ou au sommet du cône 320', 320'''.

Cette buse de pulvérisation 6 est reliée à une source d'alimentation en un liquide favorisant la séparation des substrats, tel que de l'eau déionisée, cette source n'étant pas représentée sur les figures.

Le fonctionnement du dispositif de séparation est le suivant.

La structure à séparer comprenant les deux substrats est introduite dans le dispositif de séparation de façon qu'une portion de son bord repose dans la gorge 21 de l'organe de retenue 2, respectivement la gorge 21' de l'organe de retenue 2'. La forme en arc de cercle de l'organe de retenue 2, 2' épouse le contour du bord de la structure à séparer en forme de disque.

Des moyens de retenue temporaire 7, représentés uniquement de façon schématique sur la figure 8, permettent de maintenir la structure à séparer dans un plan vertical qui se confond avec les plans P1, P2, P3, P4, P5 et/ou P6. Il s'agit par exemple de doigts escamotables, mobiles latéralement vers l'intérieur ou l'extérieur (flèches H).

Une fois que l'organe de retenue 2, 2' et l'outil de séparation 3, 3', 3", 3''' sont suffisamment rapprochés l'un de l'autre pour que l'arête avant 323, 303" ou le sommet 320', 320''' de l'outil de séparation 3' respectivement 3''' soit au contact des chanfreins bordant les deux substrats constituant la structure à séparer, ces moyens de retenue temporaire 7 sont écartés.

Le déplacement de l'organe de retenue 2, 2' et/ou de l'outil de séparation 3, 3', 3", 3''' est poursuivi jusqu'à ce que l'outil de séparation qui pénètre entre les deux substrats exerce un effet de coin et provoque la séparation de ladite structure, le long d'une interface de séparation, comme décrit précédemment.

Grâce aux caractéristiques de l'invention, et notamment à la forme du bord d'attaque de l'outil de séparation 3, 3', 3", 3''', le processus de séparation est amélioré.

La partie effilée 32, 32', 32", 32''' permet d'assurer un meilleur contrôle de la progression de l'outil au début de son insertion entre les deux substrats, puisque sa distance de pénétration correspond à un faible écartement de ces deux substrats. En outre, la résultante des forces J exercées par ladite partie effilée sur le bord des substrats S (voir figure 2) est presque perpendiculaire au plan de séparation des deux substrats, ce qui améliore l'efficacité de la séparation.

La partie évasée 33, 33', 33", 33''' permet quant à elle de propager l'onde de séparation, de renforcer l'effet de "coin" durant la séparation et de limiter le risque de rayures sur les faces des substrats situées de part et d'autre de l'interface de séparation. En effet, dès que l'outil de séparation pénètre un peu plus entre les deux substrats, ces derniers ne reposent plus que par leur bordure, sur les faces de la partie évasée et ne sont plus du tout en contact avec la partie effilée 32, 32', 32", 32'''.

Par ailleurs, grâce à la disposition préférentiellement verticale du dispositif de séparation, combinée à la forme de la gorge 21, 21' munie de parois latérales inclinées 211, 211' et 212, 212', la structure à séparer n'est soumise à aucune contrainte extérieure durant la séparation, (hormis l'action de l'outil 3, 3', 3", 3"). De ce fait, les deux substrats s'écartent librement l'un de l'autre, sous l'effet de leur propre poids, une fois la séparation initiée et viennent reposer chacun contre les parois inclinées 211, 211' et 212, 212'. Ceci n'était pas le cas avec le dispositif de l'art antérieur décrit dans le document US 7 406 994 précité.

Les deux substrats se trouvent alors dans des positions suffisamment écartées l'une de l'autre pour ne pas se retrouver de nouveau en contact accidentellement.

Lorsque l'on utilise l'organe de retenue 2', on notera que l'ergot 213 tend à être enfoncé dans l'évidement 215, à l'encontre de la force du ressort 214, sous l'action du poids de la structure. Une fois la séparation effectuée, l'ergot tend à revenir dans sa position d'origine dans laquelle il participe encore à empêcher que les deux substrats précédemment séparés ne reviennent au contact l'un de l'autre.

Enfin, on notera que l'effet bénéfique sur la séparation, obtenu grâce à la forme de l'outil de séparation, serait également obtenu même si le dispositif de séparation était disposé horizontalement.

La buse de pulvérisation 6 est utilisée pour injecter un liquide de séparation une fois l'écartement des deux substrats initié, ce qui a pour effet de favoriser la propagation de l'onde de séparation.

## Revendications

1. Dispositif de séparation de deux substrats au niveau d'une interface dite "de séparation", au moins l'un de ces deux substrats étant destiné à être utilisé dans l'électronique, l'optique, l'optoélectronique et/ou le photovoltaïque, ces deux substrats formant ensemble une structure, ce dispositif comprenant :

   - un support (1),
   - un organe de retenue (2, 2') de ladite structure, monté sur ledit support (1),
   - un outil de séparation (3, 3') desdits deux substrats, également monté sur ledit support (1),
   - des moyens de déplacement (4) dudit outil de séparation (3, 3') et/ou des moyens de déplacement (5) dudit organe, de retenue (2, 2'), ces moyens de déplacement (4, 5) permettant de déplacer cet outil (3,3') et/ou cet organe (2, 2'), par rapport audit support (1), de façon à les rapprocher ou à les écarter l'un de l'autre, de préférence sur une course limitée,

   dans lequel ledit outil de séparation (3, 3') comprend un bord d'attaque (30, 30') qui présente, en section transversale, successivement depuis son sommet (320') ou son arête avant (323) jusque vers l'arrière, une partie effilée (32, 32') qui se prolonge par une partie évasée (33, 33') et en ce que ledit outil de séparation (3, 3') présente un plan de symétrie vertical longitudinal (P1, P2) passant par son sommet (320') ou son arête avant (323); et ce dispositif de séparation étant **caractérisé en ce que** la partie effilée (32, 32') de l'outil de séparation (3, 3') présente une section transversale en forme de triangle isocèle dont l'angle au sommet (α) est inférieur à 30°, et **en ce que** la partie évasée (33, 33') présente une section transversale en forme de trapèze isocèle dont l'angle au sommet (β) est supérieur à 30°.

2. Dispositif selon la revendication 1, dans lequel la hauteur (H1) du triangle isocèle de ladite partie effilée (32, 32') est comprise entre 2 mm et 20 mm, en ce que la hauteur (H2) du trapèze isocèle de la partie évasée (33, 33') est comprise entre 10 mm et 100 mm, et en ce que l'épaisseur (e) de l'outil de séparation (3, 3') prise au niveau de la base du trapèze de la partie évasée (33, 33') est supérieure à deux fois le produit de la tangente de la moitié de l'angle au sommet (α) de la partie effilée (32, 32') par la hauteur (H1) de, celle-ci.

3. Dispositif selon l'une des revendications précédentes, dans lequel le bord d'attaque (30) de l'outil de séparation (3) est un élément rectiligne allongé.

4. Dispositif selon l'une des revendications précédentes, dans lequel ledit outil de séparation (3, 3') est réalisé dans un matériau à faible coefficient de friction, tel que du polytétrafluoroéthylène ou dans un matériau recouvert d'un lubrifiant.

5. Dispositif selon l'une des revendications précédentes, dans lequel ledit organe de retenue (2, 2') comprend une gorge de retenue verticale (21 , 21'), de préférence en forme d'arc de cercle, comprenant un fond (210, 210') et deux parois latérales (211 , 211' ; 212, 212') inclinés vers le haut et l'extérieur, et qui forment entre elles un angle (α) supérieur ou égal à 8°, cette gorge permettant de retenir ladite structure ou lesdits deux substrats dans une position verticale ou sensiblement verticale, et en ce que lesdits moyens de déplacement (4) et/ou (5) assurent le déplacement de l'outil de séparation (3, 3') et/ou de l'organe de retenue (2, 2') dans un plan vertical.

6. Dispositif selon la revendication 5, dans lequel :

   - la gorge de retenue (21, 21') présente un plan de symétrie (P5, P6) vertical, longitudinal, passant par son fond (210, 210'),
   - ledit organe de retenue (2, 2') et ledit outil de séparation (3, 3') sont montés sur ledit support (1), de façon que l'outil de séparation (3, 3') soit situé au-dessus de l'organe de retenue (2, 2') et que leurs plans de symétrie verticaux respectifs (P1, P2, P5, P6) soient confondus.

7. Dispositif selon la revendication 5 ou 6, dans lequel l'organe de retenue (2, 2') présente un fond (210, 210') dont la largeur (11, 12) est comprise entre environ 1 ,5 mm et 4 mm et/ou dont la profondeur (H4, H5) est d'au moins 10 mm.

8. Dispositif selon l'une des revendications 5 à 7, dans lequel le fond (210, 210') de l'organe de retenue (2, 2') est muni d'un ergot central (213) faisant saillie verticalement.

9. Dispositif selon la revendication 8, dans lequel ledit ergot (213) présente une hauteur (H6) comprise en-

7

tre 50 µm et 600 µm et une largeur (13) comprise entre 50 µm et 300 µm.

10. Dispositif selon la revendication 8 ou 9, dans lequel ledit ergot' (213) est monté mobile verticalement sur un ressort (214) logé dans un évidement (215) ménagé dans le fond de la gorge (21, 21').

11. Dispositif selon l'une quelconque des revendications précédentes, dans lequel l'outil de séparation (3, 3') est muni dans sa partie centrale d'une buse de pulvérisation (6), reliée à une source d'alimentation en un liquide favorisant la séparation, tel que de l'eau déionisée.

**Patentansprüche**

1. Vorrichtung zum Trennen zweier Substrate an einer so genannten "Trenn"-Schnittstelle, wobei mindestens eines dieser zwei Substrate für die Verwendung in der Elektronik, Optik, Optoelektronik und/oder Photovoltaik ausgelegt ist und die zwei Substrate zusammen eine Struktur bilden, und wobei diese Vorrichtung Folgendes umfasst:

 - eine Halterung (1),
 - ein Halteelement (2, 2') der besagten Struktur, das an der besagten Halterung (1) montiert ist,
 - ein Trennwerkzeug (3, 3') für die Trennung besagter zweier Substrate, das ebenfalls an besagter Halterung (1) montiert ist,
 - Bewegungsmittel (4) zum Bewegen des besagten Trennwerkzeugs (3, 3') und/oder Bewegungsmittel (5) zum Bewegen des besagten Halteelements (2, 2'), welche Bewegungsmittel (4, 5) das Bewegen dieses Werkzeugs (3, 3') und/oder dieses Elements (2, 2') in Bezug auf besagte Halterung (1) derart ermöglichen, dass sie sich zueinander hin- oder voneinander wegbewegen, vorzugsweise über einen begrenzten Weg,
 wobei besagtes Trennwerkzeug (3, 3') eine Angriffskante (30, 30') umfasst, die im Querschnitt nacheinander von ihrer Spitze (320') oder ihrer Vorderkante (323) bis nach hinten einen sich verjüngenden Abschnitt (32, 32') aufweist, der in einen sich erweiternden Abschnitt (33, 33') übergeht, und wobei das besagte Trennwerkzeug (3, 3') eine vertikale Längssymmetrieebene (P1, P2) aufweist, die durch seine Spitze (320') oder seine Vorderkante (323) verläuft; und
 diese Trennvorrichtung **dadurch gekennzeichnet ist, dass** der sich verjüngende Abschnitt (32, 32') des Trennwerkzeugs (3, 3') einen Querschnitt in Form eines gleichschenkligen Dreiecks aufweist, dessen Winkel in der Spitze (α) kleiner als 30° ist, und dass der sich erweiternde Abschnitt (33, 33') einen Querschnitt in Form eines gleichschenkligen Trapezes aufweist, dessen Winkel in der Spitze (β) größer als 30° ist.

2. Vorrichtung nach Anspruch 1, wobei die Höhe (H1) des gleichschenkligen Dreiecks des besagten sich verjüngenden Abschnitts (32, 32') zwischen 2 mm und 20 mm liegt, wobei die Höhe (H2) des gleichschenkligen Trapezes des sich erweiternden Abschnitts (33, 33') zwischen 10 mm und 100 mm liegt, und wobei die Dicke (e) des Trennwerkzeugs (3, 3') an der Basis des Trapezes des sich erweiternden Abschnitts (33, 33') größer ist als das zweifache Produkt aus der Tangente des halben Winkels in der Spitze (α) des sich verjüngenden Abschnitts (32, 32') und der Höhe (H1) dieses Abschnitts.

3. Vorrichtung nach einem der vorhergehenden Ansprüche, wobei die Angriffskante (30) des Trennwerkzeugs (3) ein gerades langgestrecktes Element ist.

4. Vorrichtung nach einem der vorhergehenden Ansprüche, wobei das besagte Trennwerkzeug (3, 3') aus einem Material mit einem geringen Reibungskoeffizienten, beispielsweise Polytetrafluorethylen, oder aus einem mit einem Schmierstoff überzogenen Material besteht.

5. Vorrichtung nach einem der vorhergehenden Ansprüche, wobei das besagte Halteelement (2, 2') eine vertikale, vorzugsweise kreisbogenförmige Haltenut (21, 21') umfasst, die einen Boden (210, 210') und zwei Seitenwände (211, 211'; 212, 212') umfasst, die nach oben und nach außen geneigt sind und die untereinander einen Winkel (α) ausbilden, der größer oder gleich 8° ist, und welche Haltenut es ermöglicht, die besagte Struktur oder die besagten zwei Substrate in einer vertikalen oder im Wesentlichen vertikalen Position zu halten, und wobei die besagten Bewegungsmittel (4) und/oder (5) das Bewegen des Trennwerkzeugs (3, 3') und/oder des Halteelements (2, 2') in einer vertikalen Ebene gewährleisten.

6. Vorrichtung nach Anspruch 5, wobei:

 - die Haltenut (21, 21') eine vertikale, longitudinale Symmetrieebene (P5, P6) aufweist, die durch ihren Boden (210, 210') verläuft,
 - besagtes Halteelement (2, 2') und besagtes Trennwerkzeug (3, 3') an besagter Halterung (1) dergestalt montiert sind, dass sich das Trennwerkzeug (3, 3') über dem Halteelement (2, 2') befindet und dass ihre jeweiligen vertikalen Symmetrieebenen (P1, P2, P5, P6) deckungsgleich sind.

**7.** Vorrichtung nach Anspruch 5 oder 6, wobei das Halteelement (2, 2') einen Boden (210, 210') aufweist, dessen Breite (11, 12) zwischen 1,5 mm und 4 mm liegt und/oder dessen Tiefe (H4, H5) mindestens 10 mm beträgt.

**8.** Vorrichtung nach einem der Ansprüche 5 bis 7, wobei der Boden (210, 210') des Halteelements (2, 2') mit einer zentralen, vertikal vorstehenden Nase (213) ausgerüstet ist.

**9.** Vorrichtung nach Anspruch 8, wobei besagte Nase (213) eine Höhe (H6) zwischen 50 μm und 600 μm und eine Breite (13) zwischen 50 μm und 300 μm aufweist.

**10.** Vorrichtung nach Anspruch 8 oder 9, wobei besagte Nase (213) vertikal beweglich auf einer Feder (214), die sich in einer im Boden der Nut (21, 21') angeordneten Aussparung (215) befindet, montiert ist.

**11.** Vorrichtung nach einem der vorhergehenden Ansprüche, wobei das Trennwerkzeug (3, 3') in seinem zentralen Abschnitt mit einer Zerstäubungsdüse (6), die mit einer Versorgungsquelle für eine die Trennung begünstigende Flüssigkeit, beispielsweise deionisiertes Wasser, verbunden ist, ausgerüstet ist.

**Claims**

**1.** A device for separating two substrates at an interface termed a "separation interface", at least one of the two substrates being intended to be used in electronics, optics, optoelectronics and/or photovoltaics, the two substrates together forming a structure, the device comprising:

- a support (1),
- a member (2, 2') for retaining said structure, the member being mounted on said support (1),
- a tool (3, 3') for separating said two substrates, also mounted on said support (1),
- means (4) for displacing said separating tool (3, 3') **and/or** means (5) for displacing said retaining member (2, 2'), the displacement means (4, 5) allowing the tool (3, 3') **and/or** the member (2, 2') to be displaced with respect to said support (1) in a manner **such as** to bring them closer together or move them apart from each other, **preferably** over a **limited** range, in which said separating tool (3, 3') **comprises** a leading edge (30, 30') having, in cross section and in succession from its tip (320') or its front edge (323) to the back, a tapered portion (32, 32') which is extended by a flared portion (33, 33'),

and in that said separating tool (3, 3') has a longitudinal, vertical plane of symmetry (P1, P2) passing through its tip (320') or its front edge (323); and

said separating **device** being **characterized in that** the tapered portion (32, 32') of the separating tool (3, 3') has a cross section in the form of an isosceles triangle the apex angle (α) of which is less than 30°, and **in that** the flared portion (33, 33') has a cross section in the form of an isosceles trapezium **wherein** the apex angle (β) is more than 30°.

**2.** The device as claimed in claim 1, in which the height (H1) of the isosceles triangle of said tapered portion (32, 32') is in the range 2 mm to 20 mm, and in that the height (H2) of the isosceles trapezium of the flared portion (33, 33') is in the range 10 mm to 100 mm, and in that the thickness (e) of the separating tool (3, 3') measured level with the base of the trapezium of the flared portion (33, 33') is more than two times the product of the tangent of half the apex angle (a) of the tapered portion (32, 32') and the height (H1) thereof.

**3.** The device as claimed in one of the preceding claims, in which the leading edge (30) of the separating tool (3) is an elongate rectilinear element.

**4.** The device as claimed in one of the preceding claims, in which said separating tool (3, 3') is produced from a material with a low coefficient of friction, such as polytetrafluoroethylene, or from a material coated with a lubricant.

**5.** The device as claimed in one of the preceding claims, in which said retaining member (2, 2') comprises a vertical retaining groove (21, 21'), preferably in the form of an arc of a circle, comprising a bottom (210, 210') and two side walls (211, 211'; 212, 212') which are upwardly and outwardly inclined and which between them form an angle (a) of 8° or more, said groove allowing said structure or said two substrates to be retained in a vertical or substantially vertical position, and in that said displacement means (4) and/or (5) ensure the displacement of the separating tool (3, 3') and/or of the retaining member (2, 2') in a vertical plane.

**6.** The device as claimed in claim 5, in which:

- the retaining groove (21, 21') has a longitudinal, vertical plane of symmetry (P5, P6) passing through its bottom (210, 210')
- said retaining member (2, 2') and said separating tool (3, 3') are mounted on said support (1) in a manner such that the separating tool (3, 3') is located above the retaining member (2, 2') and such that their respective vertical planes of symmetry (P1, P2, P5, P6) are coincident.

7. The device as claimed in claim 5 or claim 6, in which the retaining member (2, 2') has a bottom (210, 210') wherein the width (11, 12) is in the range 1.5 mm to 4 mm and/or wherein the depth (H4, H5) is at least 10 mm.

8. The device as claimed in one of claims 5 to 7, in which the bottom (210, 210') of the retaining member (2, 2') is provided with a central pin (213) which protrudes vertically.

9. The device as claimed in claim 8, in which said pin (213) has a height (H6) in the range 50 $\mu$m to 600 $\mu$m and a width (13) in the range 50 $\mu$m to 300 $\mu$m.

10. The device as claimed in claim 8 or claim 9, in which said pin (213) is mounted so as to be vertically movable on a spring (214) housed in a recess (215) provided in the bottom of the groove (21, 21').

11. The device as claimed in one of the preceding claims, in which the central portion of the separating tool (3, 3') is provided with a spray nozzle (6) connected to a source for supplying a liquid which promotes separation, such as deionized water.

## FIG. 1

## FIG. 2

## FIG. 3

EP 2 893 555 B1

EP 2 893 555 B1

**FIG. 4**

**FIG. 5**

13

## FIG. 6

## FIG. 7

## FIG. 8

**FIG. 9**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0824267 A1

- US 7406994 B

**Littérature non-brevet citée dans la description**

- **W.P MASZARA ; G. GOETZ ; A. CAVIGLIA ; J. B. MCKITTERICK.** *J. Appl Phys.,* 1988, vol. 64, 4943